# EUROPÄISCHE PATENTSCHRIFT

(11) **EP 1 670 056 B1**
(45) Veröffentlichungstag und Bekanntmachung des Hinweises auf die Patenterteilung: **11.06.2014**
(21) Anmeldenummer: 05025505.8
(22) Anmeldetag: 23.11.2005
(51) Int. Cl.: H01L 23/051, H01L 23/043

(54) **Leistungshalbleitermodul mit Hilfsanschluss**
Power semiconductor module with auxiliary connector
Module semi-conducteur de puissance avec un connecteur auxiliaire

(30) Priorität: 08.12.2004 DE 102004058946
(43) Veröffentlichungstag der Anmeldung: 14.06.2006
(73) Patentinhaber: Semikron Elektronik GmbH & Co. KG Patentabteilung, 90431 Nürnberg (DE)
(72) Erfinder: Hager, Ludwig, 90491 Nürnberg (DE)

(56) Entgegenhaltungen:
- EP-A- 0 421 344
- EP-A- 1 225 634
- DE-A1- 2 104 726
- DE-A1- 4 443 611
- FR-A- 2 079 196
- GB-A- 918 543

## Beschreibung

Es wird ein Leistungshalbleitermodul vorgeschlagen mit einer sicheren internen Verbindung des Hilfsanschlusskontakts eines darin angeordneten Leistungshalbleiterbauelements mit einem äußeren Anschlusselement. Bekannt sind verschienen Ausgestaltungen von Leistungshalbleitermodulen, beispielhaft mit einem Substrat mit einer Mehrzahl hierauf angeordneter Leistungshalbleiterbauelemente und einem diese umhüllenden Kunststoffgehäuses. Zum Teil weisen derartige Leistungshalbleitermodule auch metallische Grundplatten auf. Ebenso bekannt sind Scheibenzellen mit einem hermetisch dichten Gehäuse und meist nur einem einzelnen Halbleiterbauelement in ihrem Inneren. Die vorgeschlagenen Ausgestaltungen sind für alle Arten von Leistungshalbleitermodulen geeignet, weisen aber speziell für Scheibenzellen besondere Vorteile auf.

Die Erfindung wird daher auch am Beispiel einer Scheibenzelle beschreiben, wie sie seit langem bekannter Stand der Technik ist und vielfältig hergestellt wird. Derartige Scheibenzellen bestehen wie beispielhaft an der DE 101 32 169 A1 ersichtlich aus einem zylinderförmigen lsolierstoffkörper als Gehäuse. Hierin angeordnet ist mindestens ein Leistungshalbleiterbauelement, beispielhaft eine Leistungsdiode, eine Leistungstransistor oder ein Leistungsthyristor. Die Erfindung betrifft hier hauptsächlich diejenigen Scheibenzellen mit gesteuerten Leistungshalbleiterbauelementen in ihrem Inneren.

Unter Hilfsanschluss wird daher hauptsächlich die Verbindung des Steueranschlusses des Leistungshalbleiterbauelements verstanden. Ebenso sind aber auch Hilfsemitteranschlüsse oder Anschlüsse für im Leistungshalbleitermodul integrierte Sensoren unter dem Begriff subsumiert.

Die Hilfsanschlüsse einer Scheibenzelle sind nach dem Stand der Technik ausgestaltet als eine Kontakteinrichtung zur Verbindung des Hilfsanschlusses mit dem Hilfsanschlusskontakt des Leistungshalbleiterbauelements, einem Verbindungselement und einem Kontaktelement zur Verbindung mit einem äußeren Anschlusselement, in der Regel einer Durchkontaktierung des Gehäuses.

Die Kontakteinrichtung zur Verbindung des Hilfsanschlusses mit dem Hilfsanschlusskontakt des Leistungshalbleiterbauelements ist entweder als stoffschlüssige Verbindung, meist als Lötverbindung, oder als stoffbündige Verbindung, meist als Druckkontaktierung, ausgestaltet. Lötverbindung sind in der Regel nachteilig, das sie im Vergleich mit anderen Verbindungstechniken die geringste Dauerhaltbarkeit aufweisen. Druckkontaktierte Verbindungen sind in eine Vielzahl von Varianten bekannt, wobei eine neuere Variante in der nicht vorveröffentlichten DE 10 2004 050 588 offenbart wird.

Ausgehend von dieser Kontakteinrichtung besteht der Hilfsanschluss meist aus einem elektrisch isolierten Drahtelement, das an dem Anschlusselement angelötet oder angeschweißt ist. Hierbei hat die Schweißverbindung den Vorteil der größeren Dauerhaltbarkeit. Alle bekannten stoffbündigen Lösungen weisen den Nachteil auf, dass durch deren Herstellung das Innere der Scheibenzelle, speziell einer der eng benachbarten Lastanschlusskontakte verschmutz wird und somit die Dauerhaltbarkeit beeinträchtigt wird. Lötverbindung weisen zudem den Nachteil auf, dass durch die Herstellung einer Lötverbindung beim externen Anschluss die interne Lötverbindung gelöst wird.

Für Leistungshalbeitermodule mit einem Substrat ist es ebenfalls notwendig, dass die Hilfsanschlüsse, ausgehend von den Leistungshalbleitbauelementen oder von Leiterbahnen des Substrats als sichere und dauerhaltbare elektrische Verbindungen ausgestaltet sind.

Aus der FR 2 079 196 ist ein Halbleitermodul bekannt

Aus der EP 0421 344 A1 ist ein Halbleitermodul, das ein halbleitendes Substrat aufweist, bekannt.

Aus der EP 1 225 634 A2 ist ein Halbleitermodul, das mehrere halbleitende Elemente aufweist, bekannt.

Aus der GB 918 543 ist ein elektrischer Gleichrichter, der ein halbleitendes Material aufweist, bekannt.

Aus der DE 44 43 611 A1 ist ein Gate-Anschlußsystem für einen unter Druck zusammengebauten Hochleistungs-Thyristor mit Gate-Mittelelektrode bekannt.

Der Erfindung liegt die Aufgabe zugrunde ein Leistungshalbleitermodul, vorzugsweise eine Scheibenzelle, vorzustellen, mit einem äußeren Anschlusselement für Hilfsanschlüsse eines Leistungshalbleiterbauelements und / oder eines Substrats welches eine sichere und dauerhaltbare elektrische Verbindung erlaubt und welches einer einfachen Montage zugänglich ist.

Die Aufgabe wird erfindungsgemäß gelöst, durch die Maßnahmen der Merkmale des Anspruchs 1. Bevorzugte Ausführungsformen sind in den Unteransprüchen beschrieben.

Das erfindungsgemäße Leistungshalbleitermodul weist ein Gehäuse, mindestens ein im Inneren des Gehäuses angeordnetes Leistungshalbleiterbauelement sowie mindestens zwei Last- und mindestens einen Hilfsanschluss auf. Besonders bevorzugt ist, bei einem als Scheibenzelle ausgebildet Leistungshalbleitermodul, dass dessen Gehäuse mit dem äußeren Anschlusselementen hermetisch dicht ausgebildet ist.

Das Leistungshalbleitermodul weist weiterhin mindestens einen Hilfsanschluss von dem Leistungshalbleiterbauelement, vorzugsweise von dessen Steueranschlusskontakt, ausgehend auf. Alternativ kann dieser Hilfsanschluss auch von einem Substrat ausgehen. Der jeweilige Hilfsanschluss endet an einem zugeordneten äußeren Anschusselement, wobei das jeweilige äußere Anschlusselement das Gehäuse durchdringt. Im Inneren des Gehäuses ist dieses Anschlusselement hierbei als stiftartiges Metallformteil ausgebildet.

Der Hilfsanschluss selbst wird gebildet durch eine Kontakteinrichtung am Hilfsanschlusskontakt des Leistungshalbleiterbauelements bzw. einem entsprechenden Anschlusskontakt des Substrats, weiterführend mittels eines elektrisch leitenden Verbindungselements und endend in ein zum Teil als Klemmscheibe ausgebildeten Kontaktelement. Hierbei ist die Klemmscheibe auf dem stiftartigen Metallformteil des äußeren Anschlusselements angeordnet.

Das Kontaktelement ist ausgebildet als ein Metallformteil mit einem Crimpanschluss zur Quetschverbindung mit dem als elektrisch isoliertes Drahtelement ausgestalteten Verbindungselement. Die Klemmscheibe ist ausgebildet als ein äußerer Ring mit einer Mehrzahl, vorzugsweise drei oder fünf, freigestellter Klemmlippen.

Bevorzugt ist die Kontakteinrichtung am Hilfsanschlusskontakt des Leistungshalbleiterbauelements ausgebildet als ein Kunststoffformteil zur Fixierung eines Kontaktzapfens und als ein Federelement zur druckkontaktierten Verbindung des Kontaktzapfens mit dem Hilfsanschlusskontakt des Leistungshalbleiterbauelements..

Der erfinderische Gedanke wird anhand des Ausführungsbeispiels der Fig. 1 bis 3 näher erläutert.
Fig. 1 zeigt eine dreidimensionale Darstellung einer Scheibenzelle.
Fig. 2 zeigt einen Schnitt durch die Mitte dieser Scheibenzelle.
Fig. 3 zeigt das erfindungsgemäße Kontaktelement zur Verbindung des Hilfsanschlusses mit einem äußeren Anschlusselement.

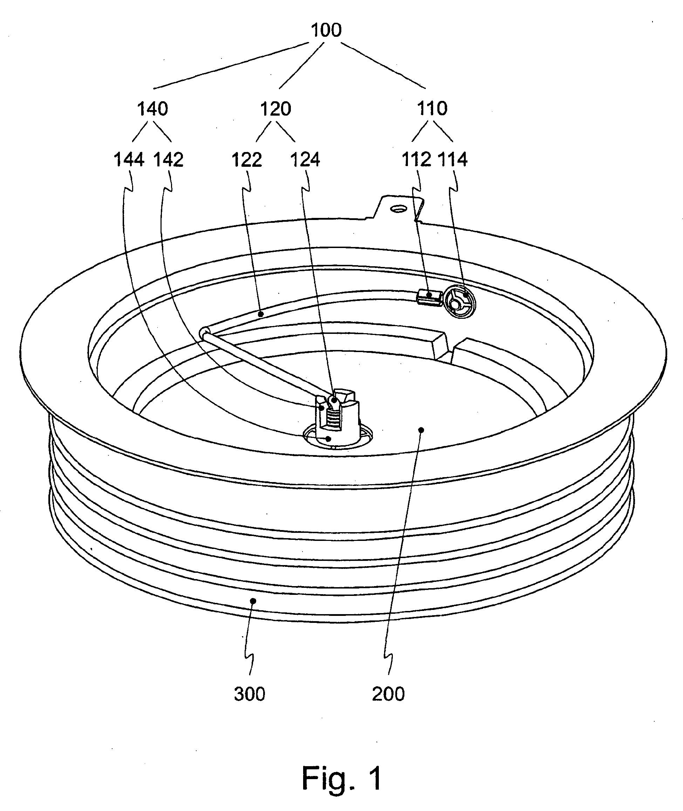

Fig. 1 zeigt einen Blick ins Innere eines erfindungsgemäßen Leistungshalbleitermoduls, hier einer Scheibenzelle. Dargestellt ist ein Keramikgehäuse (300), hierin angeordnet ein Leistungshalbleiterbauelement (200) hier speziell ein Leistungsthyristor. Der Leistungsthyristor (200) weist einen zentral gelegenen Hilfsanschlusskontakt, hier den Steueranschlusskontakt, auf. Die restliche Fläche dient als Last-, hier als Kathodenkontakt. Dessen Lastanschluss nach außen ist hier nicht gezeigt, entspricht allerdings im Wesentlichen dem Stand der Technik, weist also eine Ausnehmung zur Anordnung des Hilfsanschlusses (100) auf.

Der Hilfsanschluss (100) selbst wird gebildet aus einer Kontakteinrichtung (140), einem elektrisch leitenden Verbindungselement (120) und einem zum Teil als Klemmscheibe (114) ausgebildeten Kontaktelement (110). Hierbei ist das Verbindungselement ausgebildet als ein Kontaktzapfen (124) mit einem anschließenden Drahtelement (122). Der Kontaktzapfen ist mittels der Kontakteinrichtung (140) gehaltert und geführt. Diese Kontakteinrichtung (140) besteht aus einem Kunststoffformkörper (144) und einem Federelement (142). Der Kontaktzapfen (124) ist derart ausgebildet, dass nach der Montage der Scheibenzelle Druck auf die Kontakteinrichtung (120) ausgeübt wird, diese den Kontaktzapfen (130) auf den Hilfsanschlusskontakt des Leistungshalbleiterbauelements (200) drückt und somit den Hilfsanschluss (100) sicher und dauerhaft elektrisch kontaktiert.

Das zweite Ende des Hilfsanschlusses (100) bildet das Kontaktelement (110). Dieses ist ausgebildet als ein Metallformteil mit einem Crimpanschluss (112). Hiermit ist das Drahtelement (120) mittels einer Quetschverbindung elektrisch verbunden. Das Kontaktelement (110) weist weiterhin eine Klemmscheibe (114) auf, die auf einem stiftartigen Metallformteil eines äußeren Anschlusselements angeordnet ist.

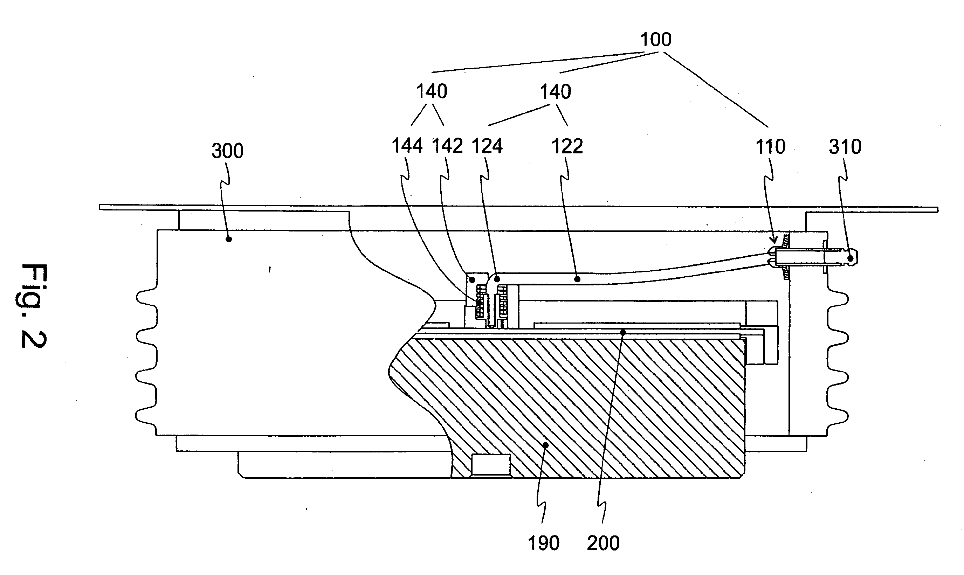

Fig. 2 zeigt einen Schnitt durch die Mitte der Scheibenzelle nach Fig. 1. Dargestellt ist ebenfalls das zylinderförmige Gehäuse (300), dessen äußere Oberfläche aus Gründen der elektrischen Sicherheit wellenförmig ausgebildet ist. Das Gehäuse (300) weist ein äußeres Anschlusselement (310) auf. Dieses Anschlusselement ist im Inneren des Gehäuses (300) als stiftartiges Metallformteil ausgebildet. Das Hautpanschlusselement (190) der Anode ist hier als metallischer Zylinder ausgebildet, auf dem eine weitere metallische Scheibe, vorzugsweise aus Molybdän, und hierauf das Leistungshalbleiterbauelement (200) angeordnet ist.

Der Hilfsanschluss (100) zur Verbindung des Hilfsanschlusskontakts des Leistungshalbleiterbauelements (200) mit dem äußeren Anschlusselement (310) wird wiederum gebildet aus der Kontakteinrichtung (140), dem elektrisch leitenden Verbindungselement (120) und dem Kontaktelement (110). Die Anordnung des Kontaktelements (110) auf dem stiftartigen Metallformteil des äußeren Anschlusselements (310) ist hier ebenfalls dargestellt.

Durch diese erfindungsgemäße Ausgestaltung des Hilfsanschlusses (100) ragt dieser im Bereich des äußeren Anschlusselements (310) nur sehr gering in den Innerraum der Scheibenzelle hinein und lässt somit ausreichend Platz für das nicht dargestellte Lastanschlusselement der Kathode. Mittels dieses Lastanschlusselements wird der Kunststoffformkörper (142) der Kontakteinrichtung (140) in Richtung des Leistungshalbleiterbauelements (200) gedruckt. Hierdurch wird mittels des Federelements (144) Druck auf den Kontaktzapfen (124) ausgeübt, der somit elektrisch sicher und dauerhaft mit dem Hilfsanschlusskontakt des Leistungshalbleiterbauelements (200) verbunden ist.

Der Hilfsanschluss (100) kann alternativ zur oben genannten Ausgestaltung auch ausgehen von einem Substrat, das als eine Hilfsplatine im Inneren des Gehäuses ausgestaltet ist. Dieses Substrat weist dann mindestens eine metallische Oberfläche auf, die mit dem Steueranschluss des Halbleiterbauelements mittels einer Drahtbondverbindung elektrisch leitend verbunden ist.

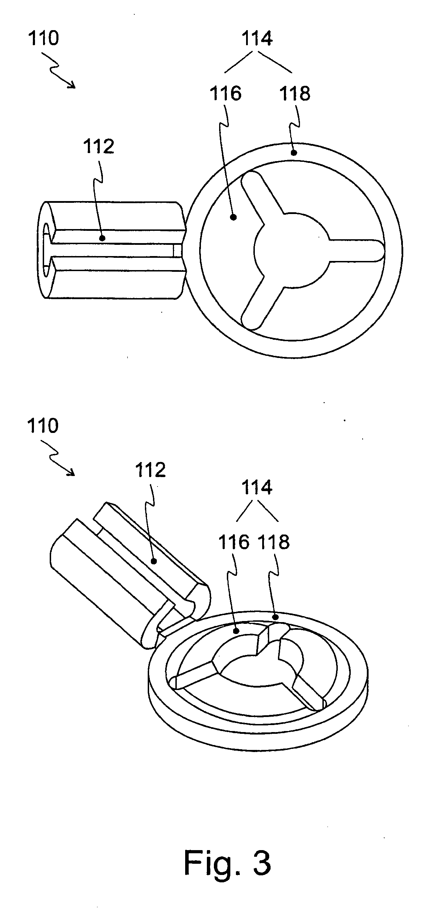

Fig. 3 zeigt das erfindungsgemäße Kontaktelement (110) sowohl in Draufsicht als auch in dreidimensionaler Darstellung. Das Kontaktelement (110) ist das Verbindungsglied des Hilfsanschlusses (100) mit einem äußeren Anschlusselement (310). Das Kontaktelement (110) ist ausgebildet als ein Metallformteil mit einem Crimpanschluss (112) zur Quetschverbindung mit dem als Drahtelement ausgestalteten Verbindungselement (120) und mit einer Klemmscheibe (112). Die Klemmscheibe besteht aus einem äußeren Ring (118) mit vorzugsweise drei, oder hier nicht dargestellten fünf, freigestellten Klemmlippen (116). Der Durchmesser der zentralen Ausnehmung der Klemmscheibe (114) ist vorzugsweise um 0,1mm bis 0,5mm geringer als der Durchmesser des stiftartigen Metallformteils des äußeren Anschlusselements (310, vgl. Fig. 1).

Es ist besonders bevorzugt, wenn die Klemmlippen (116) aus der durch den äußeren Ring (118) gebildeten Ebene heraus in Richtung des Inneren des Leistungshalbleitermoduls vorgebogen sind. Hierbei hat es sich wiederum als besonders vorteilhaft erwiesen, wenn der Tangens des Winkels der Klemmlippen zur Ebene kleiner ist als der Gleitreibungsfaktor zwischen den Werkstoffen des stiftartigen Formteils des äußeren Anschlusselements (310) und der Klemmscheibe (114). Der Winkelbereich der Vorbiegung liegt dann zwischen diesem Grenzwinkel und dem Halben Grenzwinkel. Dadurch ist die Montage auf dem stiftartigen Metallformteil des äußeren Anschlusselements (310) vereinfacht und ein Herabrutschen sicher verhindert.

## Patentansprüche

1. Leistungshalbleitermodul mit einem Gehäuse (300), mindestens einem im Inneren des Gehäuses (300) angeordneten Leistungshalbleiterbauelement (200), mindestens zwei Last- (190) und mindestens einem Hilfsanschluss (100), wobei der mindestens eine Hilfsanschluss (100) von dem Leistungshalbleiterbauelement (200) und / oder einem Substrat ausgeht und an einem zugeordneten äußeren Anschusselement (310) endet, wobei das mindestens eine äußere Anschlusselement (310) des mindestens einen Hilfsanschlusses (100) das Gehäuse (300) durchdringt und im Inneren als stiftartiges Metallformteil ausgebildet ist und wobei der Hilfsanschluss (100) gebildet wird durch eine Kontakteinrichtung (140) am Hilfsanschlusskontakt des Leistungshalbleiterbauelements (200) oder des Substrats, ein elektrisch leitendes Verbindungselement (120) und ein zum Teil als Klemmscheibe (114) ausgebildetes Kontaktelement (110), wobei die Klemmscheibe (114) auf dem stiftartigen Metallformteil des äußeren Anschlusselements (310) angeordnet ist, **gekennzeichnet dadurch dass** das Kontaktelement (110) ausgebildet ist als ein Metallformteil mit einem Crimpanschluss (112) zur Quetschverbindung mit dem als Drahtelement (122) ausgestalteten Verbindungselement (120) und der Klemmscheibe (112), die ausgestaltet ist als ein äußerer Ring (118) mit einer Mehrzahl freigestellter Klemmlippen (116).

2. Leistungshalbleitermodul nach Anspruch 1,
wobei die Klemmlippen (116) aus der durch den äußeren Ring (118) gebildeten Ebene heraus in Richtung des Inneren des Leistungshalbleitermoduls vorgebogen sind.

3. Leistungshalbleitermodul nach Anspruch 1,
wobei die Kontakteinrichtung (140) am Hilfsanschlusskontakt des Leistungshalbleiterbauelements (200) ein Kunststoffformteil zur Fixierung eines Kontaktzapfens (124) und ein Federelement zu druckkontaktierten Verbindung des Kontaktzapfens (124) mit dem Hilfsanschlusskontakt des Leistungshalbleiterbauelements (200) aufweist.

4. Leistungshalbleitermodul nach Anspruch 1,
wobei das Leistungshalbleitermodul als Scheibenzelle ausgebildet ist, deren Gehäuse (300) mit dem äußeren Anschlusselement (310) hermetisch dicht ausgebildet ist und wobei das Substrat als eine Hilfsplatine im Inneren des Gehäuse ausgestaltet ist.

## Claims

1. A power semiconductor module with a housing (300), at least one power semiconductor component (200) arranged in the interior of the housing (300), at least two load terminals (190) and at least one ancillary terminal (100), wherein
the at least one ancillary terminal (100) originates from the power semiconductor component (200) and/or a substrate, and ends at an associated external terminal element (310), wherein
the at least one external terminal element (310) of the at least one ancillary terminal (100) passes through the housing (300), and in the interior is designed as a pin-type formed metal part, and wherein
the ancillary terminal (100) is formed by means of a contact device (140) on the ancillary terminal contact of the power semiconductor component (200) or the substrate, an electrically conducting connecting element (120) and a contact element (110) designed in part as a clamping disk (114), wherein
the clamping disk is arranged on the pin-type formed metal part of the external terminal element (310),
**characterised in that**,
the contact element (110) is designed as a formed metal part with a crimped terminal (112) for purposes of providing a crimped connection between the connecting element (120), configured as a wire element (122), and the clamping disk (114), which is configured as an external ring (118) with a number of cropped clamping lips (116).

2. The power semiconductor module in accordance with Claim 1, wherein
the clamping lips (116) are initially curved out of the plane of the external ring (118) in the direction of the interior of the power semiconductor module.

3. The power semiconductor module in accordance with Claim 1, wherein
the contact device (140) on the ancillary terminal contact of the power semiconductor component (200) has a plastic moulding for purposes of fixing a contact pin (124), and a spring element for purposes of providing a pressure contact connection of the contact pin (124) with the ancillary terminal contact of the power semiconductor component (200).

4. The power semiconductor module in accordance with Claim 1, wherein
the power semiconductor module is designed as a disk cell, whose housing (300) is designed with the external connection element (310) hermetically sealed, and wherein
the substrate is configured as an ancillary board in the interior of the housing.

## Revendications

1. Module semi-conducteur de puissance avec un boîtier (300), au moins un composant semi-conducteur de puissance (200) disposé à l'intérieur du boîtier (300), au moins deux bornes de charge (190) et au moins une borne auxiliaire (100), où la ou les bornes auxiliaires (100) partant du composant semi-conducteur de puissance (200) et / ou d'un substrat et aboutissant à un élément de connexion extérieur (310) correspondant, le ou les éléments de connexion extérieurs (310) de la ou des bornes auxiliaires (100) traversant le boîtier (300) et étant réalisé(s) à l'intérieur comme pièce(s) métallique(s) moulée(s) en forme de broche, et la borne auxiliaire (100) étant formée par un dispositif de contact (140) sur le contact de borne auxiliaire du composant semi-conducteur de puissance (200) ou du substrat, un élément de liaison (120) conducteur électrique et un élément de contact (110) réalisé en partie comme rondelle de serrage (114), ladite rondelle de serrage (114) étant disposée sur la pièce métallique moulée en forme de broche de l'élément de connexion extérieur (310), **caractérisé en ce que** l'élément de contact (110) est réalisé comme une pièce métallique moulée avec un sertissage crimp (112) pour une connexion sertie avec l'élément de liaison (120) réalisé comme élément filaire métallique (122) et la rondelle de serrage (112), réalisée comme une bague extérieure (118) avec une pluralité de lèvres de serrage (116) en porte-à-faux.

2. Module semi-conducteur de puissance selon la revendication 1,
où les lèvres de serrage (116) sont cambrées hors du plan formé par la bague extérieure (118) vers l'intérieur du module semi-conducteur de puissance.

3. Module semi-conducteur de puissance selon la revendication 1,
où le dispositif de contact (140) comporte sur le contact de borne auxiliaire du composant semi-conducteur de puissance (200) une pièce moulée en matière synthétique pour la fixation d'un ergot de contact (124) et un élément de ressort pour la connexion sous pression de l'ergot de contact (124) avec le contact de borne auxiliaire du composant semi-conducteur de puissance (200).

4. Module semi-conducteur de puissance selon la revendication 1,
où ledit module semi-conducteur de puissance est réalisé comme cellule en forme de disque dont le boîtier (300) est prévu hermétiquement étanche avec l'élément de connexion extérieur (310), et où le substrat est réalisé comme platine auxiliaire à l'intérieur du boîtier.
